# EUROPEAN PATENT APPLICATION

(11) **EP 3 460 492 A1**
(43) Date of publication of application: **27.03.2019**
(21) Application number: 18179765.5
(22) Date of filing: 26.06.2018
(51) Int. Cl.: G01R 19/28

(54) **AN APPARATUS FOR MEASURING VOLTAGE OF THE ANTENNA FEED LINE**

(30) Priority: 22.09.2017 EP 17192528
(71) Applicant: Nokia Technologies Oy, 02610 Espoo (FI)
(72) Inventor: ILMONEN, Matias, 91900 Oulu (FI); NIEMI, Mika, 90620 Oulu (FI)
(74) Representative: Nokia EPO representatives

(57) **Abstract**

An apparatus, for connection in-line with an antenna feed line, comprising:
a first port for connection to a first portion of the antenna feed line;
a second port for connection to a second portion of the antenna feed line;
an antenna feed line portion connected between the first port and the second port; and
monitoring circuitry adjacent the antenna feed line portion and configured to measure voltage of the antenna feed line.

## Description

### TECHNOLOGICAL FIELD

Embodiments of the present invention relate to an apparatus for measuring voltage of the antenna feed line.

### BACKGROUND

It is sometimes desirable to measure voltage of an antenna feed line. The voltage depends upon a voltage standing wave ratio (VSWR) on the antenna line and is a useful indicator of performance.

It may be difficult to position a coupler for measuring voltage of the antenna feed line at a suitable position so that it is correctly aligned with the antenna feed line.

It may be difficult to position a coupler for measuring voltage of the antenna feed line at a fixed spatial relationship from the antenna feed line.

It may be difficult to measure the voltage of the antenna feed line without occupying space needed by other components

### BRIEF SUMMARY

According to various, but not necessarily all, embodiments of the invention there is provided an apparatus, for connection in-line with an antenna feed line, comprising:
a first port for connection to a first portion of the antenna feed line;
a second port for connection to a second portion of the antenna feed line;
an antenna feed line portion connected between the first port and the second port; and
monitoring circuitry adjacent the antenna feed line portion and configured to measure voltage of the antenna feed line.

In some, but not necessarily all examples the first port, the second port, the antenna feed line portion and the monitoring circuitry are arranged substantially in a first plane. In some, but not necessarily all examples the first plane is substantially normal to both the first portion of the antenna feed line and the second portion of the antenna feed line.

In some, but not necessarily all examples the apparatus is configured as a printed circuit board comprising the first port, the second port, the antenna feed line portion and the monitoring circuitry or as claimed in any claim. In some, but not necessarily all examples the printed circuit board extends along a first plane substantially normal to both the first portion of the antenna feed line and the second portion of the antenna feed line.

In some, but not necessarily all examples, the first port, the second port, the antenna feed line portion, and the monitoring circuitry adjacent the antenna feed line portion are located between an exterior portion of the housing of the filter and an isolating cover portion

In some, but not necessarily all examples the antenna feed line portion connected between the first port and the second port is a first antenna feed line portion connected between the first port and the second port; and the monitoring circuitry adjacent the antenna feed line portion and configured to measure voltage of the antenna feed line is first monitoring circuitry configured to measure voltage of the antenna feed line at a first frequency. The apparatus further comprising: a third port for connection to a third portion of the antenna feed line; a second antenna feed line portion connected between the first port and the third port; and second monitoring circuitry configured to measure voltage of the antenna feed line at a second frequency.

In some, but not necessarily all examples the first monitoring circuitry is adjacent the first antenna feed line portion and configured to measure voltage of the first antenna feed line portion at the first frequency; and the second monitoring circuitry is adjacent the second antenna feed line portion and configured to measure voltage of the second antenna feed line portion at the second frequency. In some, but not necessarily all examples the first antenna feed line portion and the second antenna feed line portion join at a common node connected by a common antenna feedline portion to the first port, the common antenna feedline portion provides that portion of the first antenna feed line portion between the first port and the common node, the common antenna feedline portion provides that portion of the second antenna feed line portion between the first port and the common node, that portion of the first antenna feed line portion between the second port and the common node is distinct from the second antenna feed line portion and, that portion of the second antenna feed line portion between the third port and the common node is distinct from the first antenna feed line portion.

In some, but not necessarily all examples the first port, the second port, the third port, the first antenna feed line portion, the second antenna feed line portion, the first monitoring circuitry and the second monitoring circuitry are arranged substantially in a first plane. In some, but not necessarily all examples the first plane is substantially normal to both the first portion of the antenna feed line and the second portion of the antenna feed line.

In some, but not necessarily all examples the apparatus is configured as a printed circuit board comprising the first port, the second port, the third port, the first antenna feed line portion, the second antenna feed line portion, the first monitoring circuitry and the second monitoring circuitry. In some, but not necessarily all examples, the printed circuit board extends along a first plane substantially normal to both the first portion of the antenna feed line and the second portion of the antenna feed line.

In some, but not necessarily all examples, the first port, the second port, the third port, the first antenna feed line portion, the second antenna feed line portion, the first monitoring circuitry and the second monitoring circuitry are located between an exterior portion of the housing of the filter and an isolating cover portion.

In some, but not necessarily all examples, the apparatus comprises a first filter configured to provide a lowest impedance at a first frequency and a second filter configured to provide a lowest impedance at a second frequency, wherein the first port is an antenna port for coupling to an antenna, the second port is a first filter port coupled to the first filter, and the third port is a second filter port coupled to the second filter.

In some, but not necessarily all examples, the first monitoring circuitry comprises a coupler for measuring voltage of the antenna feed line dependent upon voltage standing wave ratio (VSWR) at the first frequency and wherein the second monitoring circuitry comprises a coupler for measuring voltage of the antenna feed line dependent upon voltage standing wave ratio (VSWR) at the second frequency.

In some, but not necessarily all examples the apparatus is comprised in a base station for radio communication, In some, but not necessarily all examples the ports, the antenna feed line portion or portions, and the monitoring circuitry or circuitries are located within a vertical plane, in use within the base station. In some, but not necessarily all examples the base station comprises a filter or filters comprising manual tuning elements, arranged substantially in a horizontal plane.

According to various, but not necessarily all, embodiments of the invention there is provided a method of measuring voltage of the antenna feed line comprising:
placing a component in-line with the antenna feed line, wherein the component provides a portion of the antenna feed line and also provides monitoring circuitry adjacent the portion of the antenna feed line configured to measure voltage of the antenna feed line.

According to various, but not necessarily all, embodiments of the invention there is provided examples as claimed in the appended claims.

### BRIEF DESCRIPTION

For a better understanding of various examples that are useful for understanding the detailed description, reference will now be made by way of example only to the accompanying drawings in which:
FIG 1 shows an example embodiment of the subject matter described herein;
FIGs 2A, 2B show an example embodiment of the subject matter described herein;
FIG 3 shows an example embodiment of the subject matter described herein;
FIG 4 shows an example embodiment of the subject matter described herein;
FIG 5 shows an example embodiment of the subject matter described herein;
FIG 6 shows an example embodiment of the subject matter described herein;
FIG 7A, 7B show an example embodiment of the subject matter described herein;
FIG 8 shows an example embodiment of the subject matter described herein;
FIG 9 shows an example embodiment of the subject matter described herein;
FIG 10 shows an example embodiment of the subject matter described herein.

### DETAILED DESCRIPTION

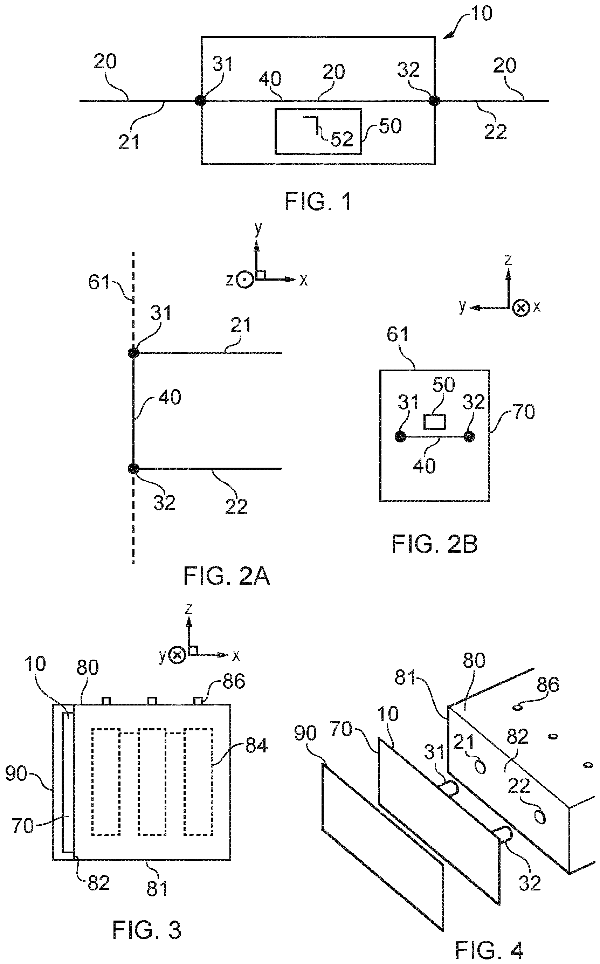

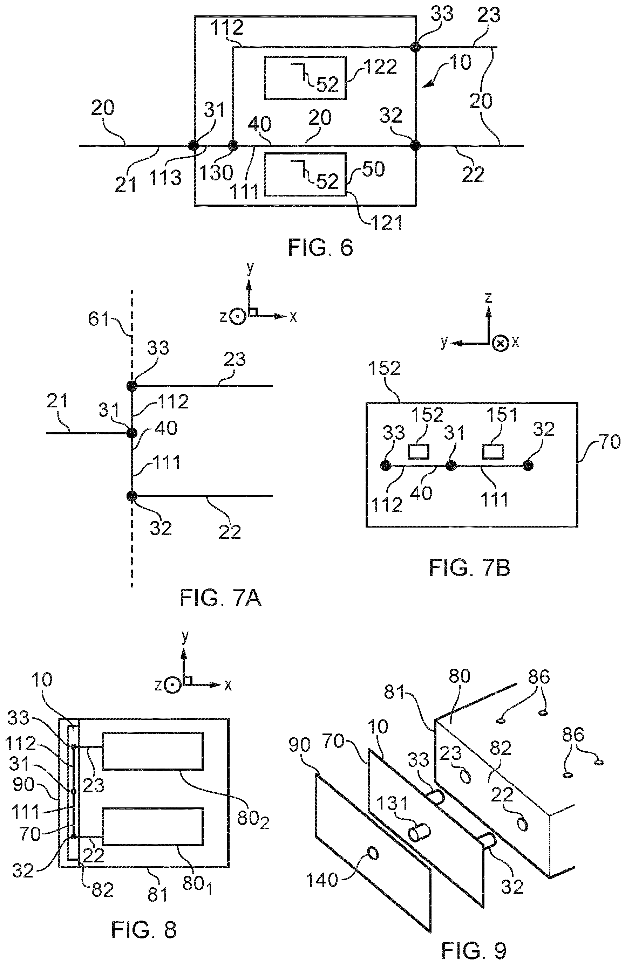

FIG 1 and FIG 6 illustrate different examples of an apparatus 10, for connection with an antenna feed line 20 to measure voltage of the antenna feed line 20.

The apparatus 10 comprises: a first port 31 for connection to a first portion 21 of the antenna feed line 20; a second port 32 for connection to a second portion 22 of the antenna feed line 20; an antenna feed line portion 40 connected between the first port 31 and the second port 32; and monitoring circuitry 50 adjacent the antenna feed line portion 40 and configured to measure voltage of the antenna feed line 20.

The first port 31 may be configured to connect to the first portion 21 of the antenna feed line 20. It may for example be a surface mounted connector on an exterior of the apparatus 10. The second port 32 may be configured to connect to the second portion 22 of the antenna feed line 20. It may for example be a surface mounted connector on an exterior of the apparatus 10.

The antenna feed line portion 40 connected between the first port 31 and the second port 32 may be a transmission line or part of a transmission line.

The monitoring circuitry 50 may comprise a coupler 52 adjacent but not in contact with the antenna feed line portion 40 and configured to measure voltage of the antenna feed line 20. The coupler 52 may be a dual coupler that enables measurement of a forward voltage and a reverse voltage of the antenna feed line 20 dependent upon voltage standing wave ratio (VSWR).

In this example, the first port 31 and the second port 32 are aligned and the antenna feed line portion 40 is straight. In other examples, the first port 31 and the second port 32 are off-set. The antenna feed line portion 40 is not always straight. However, in both circumstances the apparatus 10 is connected functionally in-line with the antenna feed line 20 to measure voltage of the antenna feed line 20. The term 'in-line' should be understood in this context as functionally in series rather than geometrically aligned.

FIGs 2A and 2B illustrates an example of an apparatus 10, for connection in-line with an antenna feed line 20 to measure voltage of the antenna feed line 20, similar to that illustrated in FIG 1 and similar references are used for similar features. FIG 2A illustrates a cross-sectional view along a x-y plane. FIG 2B illustrates a plan view of a y-z plane.

In this example, the first port 31, the second port 32, the antenna feed line portion 40 and the monitoring circuitry 50 are arranged substantially in a first plane 61 (y-z plane). The first plane 61 is substantially normal (orthogonal) to both the first portion 21 of the antenna feed line 20 and the second portion 22 of the antenna feed line 20.

In this example, the first port 31 and the second port 32 are positionally offset in a first direction (y) and the antenna feed line portion 40 connected from the first port 31 to the second port 32 extends in the first direction (y) in a negative sense (-y). The monitoring circuitry 50 is adjacent the antenna feed line portion 40 and offset from it in a second direction (z) orthogonal to the first direction (y). The first portion 21 of the antenna feed line 20 and the second portion 22 of the antenna feed line 20 extend in a third direction (x) orthogonal to the first and second directions (z=x^y). The first portion 21 of the antenna feed line 20 extends towards the first port 31 in a positive sense (+x). The second portion 22 of the antenna feed line 20 extends away from the second port 32 in a positive sense (+x).

In the example illustrated in FIGs 2A and 2B, but not necessarily all examples, the apparatus 10 is configured as a printed circuit board 70 comprising the first port 31, the second port 32, the antenna feed line portion 40 and the monitoring circuitry 50. In use, the printed circuit board 70 extends along a first plane 61 (y-z plane) substantially normal to both the first portion 21 of the antenna feed line 20 and the second portion 22 of the antenna feed line 20.

FIGs 3 and 4 illustrates an example of an apparatus 10, for connection in-line with an antenna feed line 20 to measure voltage of the antenna feed line 20, similar to that illustrated in FIG 1 and 2A & 2B and similar references are used for similar features.

The apparatus 10 is configured for connection to an exterior portion 82 of a housing 81 of a filter 80. In this example, but not necessarily all examples, the filter 80 comprises filter cavities 84 and the first portion 21 of the antenna feed line 20 and the second portion 22 of the antenna feed line 20 lie in a second plane (y-x plane) that transects the cavities 84 of the filter 80.

The first port 31, the second port 32, the antenna feed line portion 40, and the monitoring circuitry 50 adjacent the antenna feed line portion 40 are located between the exterior portion 82 of the housing 81 of the filter 80 and an isolating cover portion 90.

The first port 31, the second port 32, the antenna feed line portion 40, and the monitoring circuitry 50 adjacent the antenna feed line portion 40 lie in a first plane (y-z plane).

Manual tuning elements 86 of the filter 80 may, in some examples, be arranged substantially in a plane parallel to the second plane (x-y plane).

In the example illustrated in FIG 4, the antenna feed line portion 40 extends from the first port 31 to the second port 32 with direction and sense -y. In other examples, the apparatus 10 may be rotated by 180° about the x-axis, in which case the antenna feed line portion 40 extends from the first port 31 to the second port 32 with direction and sense +y.

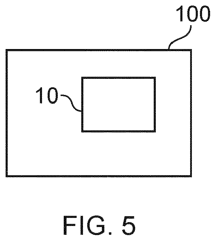

FIG 5 illustrates an example of a base station 100, for radio communication, comprising an example of an apparatus 10, for connection in-line with an antenna feed line 20 to measure voltage of the antenna feed line 20, similar to that illustrated in FIGs 1-4 and similar references are used for similar features. In this example, the first plane 61 (y-z plane) is vertical and the second plane (x-y plane) is horizontal.

Consequently in at least some examples, the first port 31, the second port 32, the antenna feed line portion 40, and the monitoring circuitry 50 adjacent the antenna feed line portion 40 are located within a vertical plane 61, in use. The base station 100 may comprise a filter 80 comprising manual tuning elements 86 arranged substantially in a horizontal plane (x-y plane).

It will be appreciated from the foregoing that in at least some examples there is provided a method of measuring voltage of the antenna feed line 20 comprising: placing a component in-line with the antenna feed line 20, wherein the component provides a portion of the antenna feed line 20 and also provides monitoring circuitry 50 adjacent the portion of the antenna feed line 20 configured to measure voltage of the antenna feed line 20.

FIG 6 illustrates an example of an apparatus 10, for connection with an antenna feed line 20 to measure voltage of the antenna feed line 20.

This example is similar to the example illustrated in FIG 1 in that the apparatus 10 comprises: a first port 31 for connection to a first portion 21 of the antenna feed line 20; a second port 32 for connection to a second portion 22 of the antenna feed line 20; an antenna feed line portion 40 connected between the first port 31 and the second port 32; and monitoring circuitry 50 adjacent the antenna feed line portion 40 and configured to measure voltage of the antenna feed line 20.

However, in this example, the antenna feed line portion 40 connected between the first port 31 and the second port 32 is a first antenna feed line portion 111 connected between the first port 31 and the second port 32 and the monitoring circuitry 50 adjacent the antenna feed line portion 40 and configured to measure voltage of the antenna feed line 20 is first monitoring circuitry 121 configured to measure voltage of the antenna feed line 20 at a first frequency.

The apparatus 10, in this example, additionally comprises: a third port 33 for connection to a third portion 23 of the antenna feed line 20; a second antenna feed line portion 112 connected between the first port 31 and the third port 33; and second monitoring circuitry 122 configured to measure voltage of the antenna feed line 20 at a second frequency.

The first port 31 may be configured to connect to the first portion 21 of the antenna feed line 20. It may for example be a surface mounted connector on an exterior of the apparatus 10. The second port 32 may be configured to connect to the second portion 22 of the antenna feed line 20. It may for example be a surface mounted connector on an exterior of the apparatus 10. The third port 33 may be configured to connect to a third portion 23 of the antenna feed line 20. It may for example be a surface mounted connector on an exterior of the apparatus 10.

The antenna feed line portion 40 connected between the first port 31, the second port 32 and the third port 33 may be a transmission line or part of a transmission line.

In this example, the first port 31, the second port 32 and the third port 33 are not necessarily aligned. The apparatus 10 is connected functionally in-line with the antenna feed line 20 to measure voltage of the antenna feed line 20. The term 'in-line' should be understood in this context as functionally in series rather than geometrically aligned.

In some examples, the first frequency may be the same as the second frequency, wherein the first monitoring circuitry 121 and the second monitoring circuitry 122 are configured to measure voltage of the antenna feed line 20 at the same frequency at different positions.

In some examples, the first frequency is different to the second frequency, wherein the first monitoring circuitry 121 and the second monitoring circuitry 122 are configured to measure voltage of the antenna feed line 20 at different frequencies at the same or different positions.

In this example, the first monitoring circuitry 121 is configured to measure voltage of the antenna feed line 20 at the first frequency but not the second frequency and the second monitoring circuitry 122 is configured to measure voltage of the antenna feed line 20 at the second frequency but not the first frequency.

In this example, the first monitoring circuitry 121 is adjacent the first antenna feed line portion 111 and configured to measure voltage of the first antenna feed line portion 111 at the first frequency and the second monitoring circuitry 122 is adjacent the second antenna feed line portion 112 and configured to measure voltage of the second antenna feed line portion 112 at the second frequency.

The first monitoring circuitry 121 may comprise a coupler 52 adjacent but not in contact with the first antenna feed line portion 111 and configured to measure voltage of the antenna feed line 20 at the first frequency. The coupler 52 may be a dual coupler that enables measurement of a forward voltage and a reverse voltage of the first antenna feed line portion 111 of the antenna feed line 20 dependent upon voltage standing wave ratio (VSWR).

The second monitoring circuitry 122 may comprise a coupler 52 adjacent but not in contact with the second antenna feed line portion 112 and configured to measure voltage of the antenna feed line 20 at the second frequency. The coupler 52 may be a dual coupler that enables measurement of a forward voltage and a reverse voltage of the second antenna feed line portion 111 of the antenna feed line 20 dependent upon voltage standing wave ratio (VSWR).

In this example, but not necessarily all examples, the first antenna feed line portion 111 and the second antenna feed line portion 112 join at a common node 130 connected by a common antenna feedline portion 113 to the first port 31. The common antenna feedline portion 113 provides that portion of the first antenna feed line portion 111 between the first port 31 and the common node 130. The common antenna feedline portion 113 provides that portion of the second antenna feed line portion 112 between the first port 31 and the common node 130.That portion of the first antenna feed line portion 111 between the second port 32 and the common node 130 is distinct from the second antenna feed line portion 112 and that portion of the second antenna feed line portion 112 between the third port 33 and the common node 130 is distinct from the first antenna feed line portion 111.

In other examples, the first antenna feed line portion 111 and the second antenna feed line portion 112 join at the first port 31. That is the common node 130 and the first port 31 are the same.

FIGs 7A and 7B illustrates an example of an apparatus 10, for connection in-line with an antenna feed line 20 to measure voltage of the antenna feed line 20, similar to that illustrated in FIG 6 and similar references are used for similar features. FIG 7A illustrates a cross-sectional view along a x-y plane. FIG 7B illustrates a plan view of a y-z plane.

In this example, the first port 31, the second port 32, the third port 33, the first antenna feed line portion 111, the second antenna feed line portion 112, the first monitoring circuitry 121 and the second monitoring circuitry 122 are arranged substantially in a first plane 61 (y-z plane). The first plane 61 is substantially normal (orthogonal) to both the first portion 21 of the antenna feed line 20 and the second portion 22 of the antenna feed line 20.

In this example, the second port 32 is positionally offset from the first port 31 in a first direction (y) and the first antenna feed line portion 111 connected from the first port 31 to the second port 32 extends in the first direction (y) in a negative sense (-y). The first monitoring circuitry 121 is adjacent the first antenna feed line portion 111 and offset from it in a second direction (z) orthogonal to the first direction (y). Also, the third port 33 is positionally offset from the first port 31 in a first direction (y) and the second antenna feed line portion 112 connected from the first port 31 to the third port 32 extends in the first direction (y) in a positive sense (+y). The second monitoring circuitry 122 is adjacent the second antenna feed line portion 112 and offset from it in a second direction (z) orthogonal to the first direction (y).

The first portion 21 of the antenna feed line 20, the second portion 22 of the antenna feed line 20 and the third portion 23 of the antenna feed line 20 extend in a third direction (x) orthogonal to the first and second directions (z=x^y). The first portion 21 of the antenna feed line 20 extends towards the first port 31 in a positive sense (+x). The second portion 22 of the antenna feed line 20 extends away from the second port 32 in a positive sense (+x). The third portion 23 of the antenna feed line 20 extends away from the third port 33 in a positive sense (+x).

In the example illustrated in FIGs 7A and 7B, but not necessarily all examples, the apparatus 10 is configured as a printed circuit board 70 comprising the first port 31, the second port 32, the third port 33, the first antenna feed line portion 111, the second antenna feed line portion112, the first monitoring circuitry 121 and the second monitoring circuitry 122. In use, the printed circuit board 70 extends along a first plane 61 (y-z plane). In this example, but not necessarily all examples, the first plane is substantially normal to both the first portion 21 of the antenna feed line 20 and the second portion 22 of the antenna feed line 20.

FIGs 8 and 9 illustrate an example of an apparatus 10, for connection in-line with an antenna feed line 20 to measure voltage of the antenna feed line 20, similar to that illustrated in FIG 1 and 2A & 2B and similar references are used for similar features.

The apparatus 10 is configured for connection to an exterior portion 82 of a housing 81 comprising a first filter 80₁ and a second filter 80₂.

The first filter 80₁ is configured to provide a lowest impedance (return loss S11) at a first frequency. The second filter 80₂ is configured to provide a lowest impedance (return loss S11) at a second frequency.

In some but not necessarily all examples, the first filter 80₁ is configured to provide a first bandpass frequency range that includes the first frequency and the second filter 80₂ is configured to provide a second bandpass frequency range that includes the second frequency. The impedance (return loss S11) is below an operational threshold value within the bandpass. In some but not necessarily all examples, the first bandpass frequency range and the second bandpass frequency range do not overlap.

The first port 21 is an antenna port for coupling to the antenna. The second port 22 is a first filter port coupled to the first filter 80₁ and the third port 23 is a second filter port coupled to the second filter 80₂.

In this example, but not necessarily all examples, the first filter 80₁ comprises filter cavities and the second filter 80₂ comprises filter cavities and the first antenna feed line portion 111 and the second antenna feedline portion 122 lie within a second plane (a y-x plane) that transects the cavities of the filters 80.

Manual tuning elements 86 of the first and second filters 80 may, in some examples, be arranged substantially in a plane parallel to the second plane (the x-y plane of the first and second antenna feed line portions 111, 112).

The first port 31, the second port 32, the third port 33, the first antenna feed line portion 111, the second antenna feed line portion 112, the first monitoring circuitry 121, and the second monitoring circuitry 122 are located between the exterior portion 82 of the housing 81 of the filter 80 and an isolating cover portion 90. In this example, an aperture 140 in the isolating cover portion 90 provides access to the first port 31.

The first port 31, the second port 32, the third port 33, the first antenna feed line portion 111, the second antenna feed line portion 112, the first monitoring circuitry 121, and the second monitoring circuitry 122 lie in a first plane (a y-z plane).

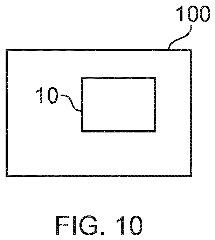

FIG 10 illustrates an example of a base station 100, for radio communication, comprising an example of an apparatus 10, for connection in-line with an antenna feed line 20 to measure voltage of the antenna feed line 20, similar to that illustrated in FIGs 6-9 and similar references are used for similar features. In this example, the first plane 61 (y-z plane) is vertical and the second plane (x-y plane) is horizontal.

Consequently in at least some examples, the first port 31, the second port 32, the third port 33, the first antenna feed line portion 111, the second antenna feed line portion 112, the first monitoring circuitry 121, and the second monitoring circuitry 122 are located within a vertical plane 61, in use. The base station 100 may comprise filters 80 comprising manual tuning elements 86 arranged substantially in a horizontal plane (x-y plane).

It will be appreciated from the foregoing that in at least some examples there is provided a method of measuring voltage of the antenna feed line 20 comprising: placing a component in-line with the antenna feed line 20, wherein the component branches the antenna feed line 20 and provides fat least first and second monitoring circuitry configured to measure voltage of the branching antenna feed line 20 at different branches and/or different frequencies.

It will be appreciated from the foregoing description, and in particular the description regarding FIGs 6 to 10, that the apparatus 10 may be configured as a component of a diplexer, that is passive frequency multiplexer.

As used in this application, the term 'circuitry' refers to all of the following:
(a) hardware-only circuit implementations (such as implementations in only analog and/or digital circuitry) and
(b) to combinations of circuits and software (and/or firmware), such as (as applicable): (i) to a combination of processor(s) or (ii) to portions of processor(s)/software (including digital signal processor(s)), software, and memory(ies) that work together to cause an apparatus, such as a mobile phone or server, to perform various functions and
(c) to circuits, such as a microprocessor(s) or a portion of a microprocessor(s), that require software or firmware for operation, even if the software or firmware is not physically present.

This definition of 'circuitry' applies to all uses of this term in this application, including in any claims. As a further example, as used in this application, the term "circuitry" would also cover an implementation of merely a processor (or multiple processors) or portion of a processor and its (or their) accompanying software and/or firmware. The term "circuitry" would also cover, for example and if applicable to the particular claim element, a baseband integrated circuit or applications processor integrated circuit for a mobile phone or a similar integrated circuit in a server, a cellular network device, or other network device.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one." or by using "consisting".

In this brief description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some of or all other examples. Thus 'example', 'for example' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example but does not necessarily have to be used in that other example.

Although embodiments of the present invention have been described in the preceding paragraphs with reference to various examples, it should be appreciated that modifications to the examples given can be made without departing from the scope of the invention as claimed.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

Whilst endeavoring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.
I/we claim:

## Claims

1. An apparatus, for connection in-line with an antenna feed line, comprising:
a first port for connection to a first portion of the antenna feed line;
a second port for connection to a second portion of the antenna feed line;
an antenna feed line portion connected between the first port and the second port; and
monitoring circuitry adjacent the antenna feed line portion and configured to measure voltage of the antenna feed line.

2. An apparatus as claimed in claim 1, wherein the antenna feed line portion connected between the first port and the second port is a first antenna feed line portion connected between the first port and the second port; and
wherein the monitoring circuitry adjacent the antenna feed line portion and configured to measure voltage of the antenna feed line is first monitoring circuitry configured to measure voltage of the antenna feed line at a first frequency;
the apparatus further comprising:
a third port for connection to a third portion of the antenna feed line;
a second antenna feed line portion connected between the first port and the
third port; and
second monitoring circuitry configured to measure voltage of the antenna feed line at a second frequency.

3. An apparatus as claimed in claim 2, wherein the first monitoring circuitry is adjacent the first antenna feed line portion and configured to measure voltage of the first antenna feed line portion at the first frequency; and
wherein the second monitoring circuitry is adjacent the second antenna feed line portion and configured to measure voltage of the second antenna feed line portion at the second frequency.

4. An apparatus as claimed in claim 2 or 3, wherein first antenna feed line portion and the second antenna feed line portion join at a common node connected by a common antenna feedline portion to the first port,
wherein the common antenna feedline portion provides that portion of the first antenna feed line portion between the first port and the common node
wherein the common antenna feedline portion provides that portion of the second antenna feed line portion between the first port and the common node
wherein that portion of the first antenna feed line portion between the second port and the common node is distinct from the second antenna feed line portion and
wherein that portion of the second antenna feed line portion between the third port and the common node is distinct from the first antenna feed line portion.

5. An apparatus as claimed in claim 1, wherein the first port, the second port, the antenna feed line portion and the monitoring circuitry are arranged substantially in a first plane or as claimed in any of claims 2 to 4 wherein the first port, the second port, the third port, the first antenna feed line portion, the second antenna feed line portion, the first monitoring circuitry and the second monitoring circuitry are arranged substantially in a first plane.

6. An apparatus as claimed in claim 5, wherein the first plane is substantially normal to both the first portion of the antenna feed line and the second portion of the antenna feed line.

7. An apparatus as claimed in claim 1, configured as a printed circuit board comprising the first port, the second port, the antenna feed line portion and the monitoring circuitry or as claimed in any claim, when dependent upon claim 2, configured as a printed circuit board comprising the first port, the second port, , the third port, the first antenna feed line portion, the second antenna feed line portion, the first monitoring circuitry and the second monitoring circuitry.

8. An apparatus as claimed in claim 7, wherein the printed circuit board extends along a first plane substantially normal to both the first portion of the antenna feed line and the second portion of the antenna feed line.

9. An apparatus as claimed in any preceding claim, wherein the first port, the second port, the antenna feed line portion, and the monitoring circuitry adjacent the antenna feed line portion are located between an exterior portion of the housing of the filter and an isolating cover portion or as claimed in any preceding claim, when dependent upon claim 2, wherein the first port, the second port, the third port, the first antenna feed line portion, the second antenna feed line portion, the first monitoring circuitry and the second monitoring circuitry are located between an exterior portion of the housing of the filter and an isolating cover portion.

10. An apparatus as claimed in any preceding claim, wherein the first monitoring circuitry comprises a coupler for measuring voltage of the antenna feed line dependent upon voltage standing wave ratio (VSWR) at the first frequency and wherein the second monitoring circuitry comprises a coupler for measuring voltage of the antenna feed line dependent upon voltage standing wave ratio (VSWR) at the second frequency.

11. An apparatus as claimed in any preceding claim, when dependent upon claim 2, comprising a first filter configured to provide a lowest impedance at a first frequency and a second filter configured to provide a lowest impedance at a second frequency, wherein
the first port is an antenna port for coupling to an antenna,
the second port is a first filter port coupled to the first filter, and
the third port is a second filter port coupled to the second filter.

12. A base station for radio communication comprising the apparatus as claimed in any preceding claim.

13. A base station as claimed in claim 12, wherein the ports, the antenna feed line portion or portions, and the monitoring circuitry or circuitries are located within a vertical plane, in use

14. A base station as claimed in claim 13, comprising a filter or filters comprising manual tuning elements, arranged substantially in a horizontal plane.

15. A method of measuring voltage of the antenna feed line comprising:
placing a component in-line with the antenna feed line, wherein the component provides a portion of the antenna feed line and also provides monitoring circuitry adjacent the portion of the antenna feed line configured to measure voltage of the antenna feed line.
